# EUROPÄISCHE PATENTSCHRIFT

(11) **EP 3 244 326 B1**
(45) Veröffentlichungstag und Bekanntmachung des Hinweises auf die Patenterteilung: **07.07.2021**
(21) Anmeldenummer: 16168899.9
(22) Anmeldetag: 10.05.2016
(51) Int. Cl.: G06F 30/331, G06F 30/34

(54) **VERFAHREN ZUM ERSTELLEN EINER FPGA-NETZLISTE**
METHOD FOR CREATING A FPGA NETLIST
PROCÉDÉ DESTINÉ A L'ÉTABLISSEMENT D'UNE LISTE DE RÉSEAU FPGA

(43) Veröffentlichungstag der Anmeldung: 15.11.2017
(73) Patentinhaber: dSPACE digital signal processing and control engineering GmbH, 33102 Paderborn (DE)
(72) Erfinder: Kalte, Heiko, 33106 Paderborn (DE); Lubeley, Dominik, 33415 Verl (DE)

(56) Entgegenhaltungen:
- US-A- 5 764 079
- US-A1- 2010 146 338
- HUTCHINGS BRAD L ET AL: "Rapid Post-Map Insertion of Embedded Logic Analyzers for Xilinx FPGAs", 2014 IEEE 22ND ANNUAL INTERNATIONAL SYMPOSIUM ON FIELD-PROGRAMMABLE CUSTOM COMPUTING MACHINES, IEEE, 11. Mai 2014 (2014-05-11), Seiten 72-79, XP032778906, DOI: 10.1109/FCCM.2014.29 [gefunden am 2014-07-21]

## Beschreibung

Die vorliegende Erfindung betrifft ein Verfahren zur Erstellung einer Netzliste für ein FPGA.

Die Echtzeitsimulation von komplexen, dynamischen Modellen stellt aufgrund der engen zeitlichen Randbedingungen selbst an moderne Rechenknoten hohe Anforderungen. In automotiven Hardware-in-the-Loop-Simulationen (HiL) werden solche Modelle vor allem dort eingesetzt, wo schnelle Regelkreise geschlossen werden müssen. Dies ist etwa bei der Simulation von Zylinderinnendrucksensoren der Fall, die bei der Verbrauchs- oder Abgasreduktion eine zunehmend größere Rolle spielen. Aber auch bei Regelstrecken die eine hohe Dynamik aufweisen, wie zum Beispiel bei Elektromotoren, sind kurze Zykluszeiten und geringe Latenzen unabdingbar. Diese können mit CPU-basierten Simulationen praktisch kaum mehr umgesetzt werden.

Field Programmable Gate Arrays (FPGAs) können Rechenknoten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von FPGAs auch harte Echtzeitanforderungen leicht erfüllen. Die FPGAs können als Hardwarebeschleuniger für CPUs von Rechenknoten dienen. Entsprechend werden z.B. sehr dynamische Teile des Umgebungsmodells in das FPGA ausgelagert, so dass ausreichend präzise und schnelle Reaktionszeiten für das Steuergerät gewährleistet bleiben. Eine FPGA-Netzliste wird üblicherweise basierend auf einem FPGA Modell in einer Hardwarebeschreibungssprache in einem Build-Prozess erzeugt.

Die Modelle einer Regelstrecke werden durch steigende Anforderungen an die Genauigkeit zunehmend komplexer und somit auch schwer handhabbar. Im automotiven Hil-Umfeld werden solche Modelle in der Regel mit dem Toolset Matlab/Simulink von The MathWorks Inc. erstellt. Simulink bietet eine blockbasierte Sicht in der Form eines Blockschaltbilds auf solche Modelle. Modellteile können in einem Blockschaltbild zu Subsystemen zusammengefasst und untereinander mit Signalen verknüpft werden. Der Datenfluss zwischen diesen Blöcken wird dabei über Signalleitungen dargestellt.

Eine FPGA-basierte Simulation kann unter Zuhilfenahme des Xilinx System Generator (XSG) und des FPGA-Programming Blocksets von dSPACE, analog zur CPU-basierten Simulation, in einem Blockschaltbild mit Simulink modelliert werden.

Im Gegensatz zur CPU-Simulation wird dieses Modell allerdings nicht in eine iterative Programmiersprache übersetzt, sondern in eine FPGA-Netzliste, die eine kundenspezifische digitale Schaltung beschreibt. Die FPGA-Netzliste kann in einen FPGA-Konfigurationsdatenstrom übersetzt werden.

Aus der EP2765528A1 ist ein Verfahren zum Auslesen von Variablen aus FPGAs zur Laufzeit bekannt.

Aus der US5764079 ist ein PLD mit shadow storage units bekannt. HUTCHINGS BRAD LET AL: "Rapid Post-Map Insertion of Embedded Logic Analyzers for Xilinx FPGAs" beschreibt die Nutzung von BlockRAM als TraceBuffer.

US 2010/146338 A1 beschreibt ein System zum Vergleichen eines FPGA mit einer HDL-Simulation.

Bei einigen Auslesetechniken werden die Daten direkt aus den Arbeitsregistern ausgelesen. Beim Auslesen zur Laufzeit des FPGAs ist dies nachteilig, da es häufig nicht möglich ist, ein Register zu einem speziellen Zeitpunkt auszulesen. Da die Arbeitsregister zur Laufzeit ständig mit aktuellen Werten überschrieben werden, kann ein zu einem speziellen Zeitpunkt vorliegender Wert häufig nicht erfasst werden.

Aufgabe der Erfindung ist es, den Stand der Technik weiterzubilden.

Die Erfindung betrifft ein Verfahren zum Erstellen einer FPGA-Netzliste, wobei die Netzliste aus einem FPGA-Quellcode und zumindest einem Schattenregister erzeugt wird,
wobei der FPGA-Quellcode zumindest eine Funktion und zumindest ein Signal definiert,
wobei das Schattenregister dem zumindest einen Signal zugeordnet wird und dazu eingerichtet und vorgesehen wird den Wert des zugeordneten Signals zur Laufzeit zu speichern,
wobei eine Möglichkeit zum Auslesen des gespeicherten Signalwertes zur Laufzeit vorgesehen und eingerichtet wird,
wobei die im FPGA-Quellcode definierte Funktion durch das Schattenregister nicht verändert wird,
wobei die Netzliste dazu vorgesehen wird auf einen FPGA geladen und von dem FPGA ausgeführt zu werden,
wobei die vom FPGA-Quellcode beschriebene Funktion vom FPGA ausgeführt wird,
wobei eine funktionale Abkopplung des Schattenregisters von der im FPGA-Quellcode beschriebenen Funktion vorgesehen und eingerichtet wird,
wobei das Schattenregister durch die Abkopplung den zum Zeitpunkt der Abkopplung gespeicherten Signalwert beibehält, während die im FPGA-Quellcode beschriebene Funktion ausgeführt wird.

Erfindungsgemäß ist ferner eine Datenverarbeitungseinrichtung mit einer Prozessoreinheit angegeben, wobei die Datenverarbeitungseinrichtung zur Durchführung des obigen Verfahrens ausgeführt ist.

Erfindungsgemäß ist auch ein Computerprogrammprodukt mit Computerimplementierten Anweisungen, das nach dem Laden und Ausführen in einer geeigneten Datenverarbeitungseinrichtung die Schritte des obigen Verfahrens ausführt, angegeben.

Weiterhin ist erfindungsgemäß ein digitales Speichermedium mit elektronisch auslesbaren Steuersignalen angegeben, die so mit einer programmierbaren Datenverarbeitungseinrichtung zusammenwirken können, dass das obige Verfahren auf der Datenverarbeitungseinrichtung ausgeführt wird.

Die Netzliste kann in einen Bitstrom umgewandelt und auf einen FPGA geladen werden. Der FPGA kann dann die im FPGA-Quellcode definierte Funktion ausführen. Durch die Abkopplung wird es möglich genau den Wert auszulesen, der zum Zeitpunkt der Abkopplung aktuell war, auch dann, wenn ein Auslesen der Signalwerte verzögert erfolgt. Zur Laufzeit ist hier so zu verstehen, dass die im FPGA-Quellcode definierte Funktion weiterhin ausgeführt wird und der Signalwert weiterhin aktualisiert wird, während der das Schattenregister abgekoppelt wird und den zum Zeitpunkt der Abkopplung aktuellen Wert beibehält. Die Abkopplung wird vorzugsweise durch ein Triggersignal ausgelöst. In der FPGA-Netzliste wird dazu der Abkopplungsmechanismus mit dem Triggersignal verbunden. Alternativ kann das Schattenregister standardmäßig abgekoppelt sein und auf ein Triggersignal hin kurzzeitig mit der Funktion verbunden werden. Dann wird im Schattenregister der zum Zeitpunkt des Triggersignals aktuelle Signalwert gespeichert und das Schattenregister wieder von der Funktion abgekoppelt.

Das Ergebnis des erfindungsgemäßen Verfahrens ist folglich eine FPGA-Netzliste, wobei in der Netzliste zumindest ein Schattenregister definiert ist, wobei in der FPGA-Netzliste zumindest eine Funktion und zumindest ein Signal definiert ist, wobei das Schattenregister mit dem zumindest einen Signal verbunden ist und dazu eingerichtet und vorgesehen ist den Wert des Signals zur Laufzeit zu speichern, wobei die Netzliste dazu vorgesehen ist auf einen FPGA geladen und von dem FPGA ausgeführt zu werden, wobei eine Möglichkeit zum Auslesen des in dem Schattenregister gespeicherten Signalwerts zur Laufzeit des FPGA in der Netzliste vorgesehen und eingerichtet ist, wobei eine funktionale Abkopplung des Schattenregisters von dem Signal vorgesehen und eingerichtet ist, wobei das Schattenregister durch die Abkopplung den zum Zeitpunkt der Abkopplung gespeicherten Signalwert beibehält, während das FPGA die Funktion ausführt.

In einer bevorzugten Ausgestaltung definiert der FPGA-Quellcode ein Vielzahl von Signalen, wobei eine Vielzahl von Schattenregistern jeweils einem Signal zugeordnet wird, wobei die funktionale Abkopplung dazu vorgesehen ist die Vielzahl an Schattenregistern synchron abzukoppeln.

Durch die synchrone Abkopplung wird es möglich eine Vielzahl von zeitgleich vorliegenden Signalwerten zur Laufzeit aus dem FPGA auszulesen. Das synchrone Auslesen mehrere Signalwerte aus einem FPGA ist häufig nicht möglich. Durch die synchron abkoppelbaren Schattenregister können zeitgleich vorliegende Signalwerte gespeichert und nacheinander ausgelesen werden. So kann ein konsistenter Datensatz von gleichzeitig vorliegenden Variablen festgehalten werden.

Das Ergebnis der bevorzugten Ausgestaltung ist eine FPGA-Netzliste, wobei in der FPGA-Netzliste eine Vielzahl von Signalen definiert ist, wobei eine Vielzahl von Schattenregistern jeweils einem Signal zugeordnet ist, wobei die funktionale Abkopplung dazu vorgesehen ist die Vielzahl von Schattenregistern synchron abzukoppeln.

In einer Ausgestaltung wird zur Abkopplung das enable-Signal des Schattenregisters oder das Taktsignal des Schattenregisters unterbrochen.

Durch die Unterbrechung des enable-Signals des Schattenregisters wird das Schattenregister zur Laufzeit nicht mehr aktualisiert. Dies stellt eine sehr einfache Möglichkeit der Abkopplung für ein oder mehrere Schattenregister dar.

Durch die Unterbrechung des Clock-Signals des Schattenregisters, nimmt das Schattenregister keine Änderungen mehr an, sodass der Zustand des Registers quasi eingefroren wird. Der im Schattenregister gespeicherte Wert kann dennoch auf verschiedene Arten ausgelesen werden.

Das Ergebnis der bevorzugten Ausgestaltung ist eine FPGA-Netzliste, wobei in der Netzliste vorgesehen ist zur Abkopplung das enable-Signal des Schattenregisters oder das Clock-Signal des Schattenregisters zu unterbrechen.

In einer Ausgestaltung liegt der FPGA-Quellcode als grafisches Modell oder als textueller Code vor.

FPGA-Quellcode liegt häufig in Form eines grafischen Modells vor, beispielsweise als Blockdiagramm in einer Entwicklungsumgebung. Beispiele für solche Blockdiagramme ist Simulink von The MathWorks. In grafischen Quellcode lassen sich Schattenregister leicht als zusätzliche Register einfügen, wobei die zusätzlichen Register mit dem zugeordneten Signal verbunden werden und über einen ebenfalls eingefügten Abkoppelmechanismus zur Laufzeit funktional vom Signal abgekoppelt werden können.

Eine alternative Form von FPGA-Quellcode ist textueller Code, beispielsweise VHDL oder Verilog. Auch in textuellen Quellcode lassen sich Schattenregister leicht als zusätzliche Register einfügen, wobei die zusätzlichen Register mit dem zugeordneten Signal verbunden werden und über einen ebenfalls eingefügten Abkoppelmechanismus zur Laufzeit funktional vom Signal abgekoppelt werden können.

In einer bevorzugten Ausgestaltung wird das Schattenregister in den FPGA-Quellcode oder eine Kopie des FPGA-Quellcodes eingefügt wird.

Durch das Einfügen des Schattenregisters direkt in den FPGA-Quellcode ist die Erstellung einer Netzliste besonders einfach, da nur der FPGA-Quellcode in eine Netzliste übersetzt werden muss. Durch das Einfügen des Schattenregisters in eine Kopie des FPGA-Quellcodes bleibt der ursprüngliche FPGA-Quellcode unangetastet. Dies ist vorteilhaft, wenn das Verfahren für den Nutzer transparent sein soll. Der Nutzer bekommt also nicht mit, dass ein Schattenregister eingefügt wurde, die Vorteile beim Auslesen des Signalwertes zur Laufzeit können trotzdem genutzt werden.

In einer alternativen Ausgestaltung wir aus dem Quellcode eine Netzliste generiert und das Schattenregister in die Netzliste eingefügt.

Durch das Einfügen der Schattenregister in die Netzliste bleibt der FPGA-Quellcode unverändert ohne dass eine Kopie angelegt werden muss. Die Netzliste mit den Schattenregistern kann danach wie jede andere Netzliste weiterverwendet werden. Beispielsweise kann sie in einen Bitstrom umgewandelt werden und auf anschließend auf einen FPGA geladen werden. Die Netzliste in die das Schattenregister eingefügt wird kann hierbei als einfache Netzliste oder mit Zusatzinformationen über Mapping, Placing und/oder Routing vorliegen.

In einer bevorzugten Ausgestaltung wird das Schattenregister automatisiert eingefügt und dem Signal zugeordnet.

Durch die Automatisierung wird der Nutzer von der Aufgabe entlastet das Schattenregister einzufügen und dem Signal zuzuordnen. Insbesondere bei einer Vielzahl von Signalen, denen jeweils ein Schattenregister zugeordnet werden soll ist die Automatisierung von großem Vorteil.

In einer weiteren Ausgestaltung wird automatisiert geprüft, ob das Signal bereits an anderer Stelle einem Schattenregister zugeordnet ist und dann diesem Signal kein weiteres Schattenregister zugeordnet.

Durch die automatisierte Prüfung wird verhindert, dass für ein Signal eine Vielzahl von Schattenregistern eingefügt und dem Signal zugeordnet werden. Insbesondere wenn der FPGA-Quellcode groß wird, also viele Zeilen Text umfasst oder als grafisches Modell eine Vielzahl von Hierarchieebenen umfasst ist eine manuelle Prüfung aufwendig und fehleranfällig und daher die automatisierte Prüfung vorteilhaft.

In einer weiteren Ausgestaltung werden mindestens zwei Schattenregister eingefügt und dem Signal zugeordnet, wobei das erste Schattenregister dazu vorgesehen und eingerichtet wird zur Laufzeit einen aktuellen Signalwert zu speichern, während das zweite Schattenregister abgekoppelt ist.

Mit zwei Schattenregistern ist es möglich einen alten Signalwert im ersten Schattenregister festzuhalten und gleichzeitig einen aktuellen Signalwert im zweiten Schattenregister aufzunehmen. Dies kann zum Beispiel eingesetzt werden, wenn der Auslesevorgang der Schattenregister mehrere FPGA-Takte dauert oder nicht sofort durchgeführt werden kann. Dann kann während des Auslesens des ersten Schattenregisters ein aktueller Wert im zweiten Schattenregister gespeichert werden.

Mehrere Schattenregister können auch ein Speicherfenster darstellen. In dem Fall wird in einem Schattenregister ein aktueller Signalwert gespeichert und in dem anderen Schattenregister ein alter Signalwert. Auf ein Triggersignal hin können die Schattenregister gleichzeitig abgekoppelt werden. Dadurch wird es möglich den Signalwert vor dem Triggersignal auszulesen.

In einer alternativen Ausführungsform kann ein Speicherfenster genutzt werden, um einen auf ein Triggersignal folgenden Signalwert festzuhalten. In dem Fall werden die Schattenregister nacheinander nach einer vorbestimmten Zeitdauer abgekoppelt.
Durch drei oder mehr Schattenregister können beide Varianten gleichzeitig genutzt werden. So wird es möglich, den Signalwert vor und nach einem Triggersignal festzuhalten und auszulesen.

Das Ergebnis der bevorzugten Ausgestaltung ist eine FPGA-Netzliste, wobei in der FPGA-Netzliste mindestens zwei Schattenregister definiert sind und dem einen Signal zugeordnet sind, wobei das erste Schattenregister dazu vorgesehen und eingerichtet ist zur Laufzeit einen aktuellen Signalwert zu speichern, während das zweite Schattenregister abgekoppelt ist.

In einer besonders bevorzugten Ausgestaltung wird beim Erstellen der Netzliste ein Auslesen des Schattenregisters über eine externe und/oder interne Readbackschnittstelle des FPGAs vorgesehen und eingerichtet.

Das Auslesen der Schattenregister über eine interne oder externe Readbackschnittstelle stellt eine komfortable Möglichkeit des Auslesens dar. Bei dieser Ausführungsform werden insbesondere sehr wenig Logik und Routingressourcen des FPGAs für das Auslesen benötigt. Das Schattenregister kann durch die Implemenierungswerkzeuge direkt neben das zugeordnete Signal platziert werden. Dadurch ist die Änderung gegenüber einer Netzliste ohne eingefügtes Schattenregister minimal.

In einer weiteren Ausgestaltung wird eine Vielzahl von Schattenregistern eingefügt, wobei die Vielzahl von Schattenregistern zu einer Schieberegisterkette verbunden werden und dazu vorgesehen und eingerichtet werden über eine externe Schnittstelle des FPGAs ausgelesen zu werden.

In einer alternativen Ausgestaltung wird eine Vielzahl von Schattenregistern eingefügt, wobei ein Adressdecoder zum Auslesen der Vielzahl von Schattenregistern über eine externe Schnittstelle des FPGA vorgesehen und eingerichtet wird.

Das Auslesen über eine externe Schnittstelle ermöglicht typischerweise einen höheren Datendurchsatz als eine Readbackschnittstelle. Daher ist diese Form des Auslesens vorteilhaft, wenn zur Laufzeit häufig viele Signalwerte ausgelesen werden sollen.

In einer weiteren Ausgestaltung wird zusätzlich zum Schattenregister eine Logik eingefügt, wobei die Logik dazu vorgesehen und eingerichtet wird zur Laufzeit bei einer Änderung des Signalwertes ein Triggersignal auszugeben, wobei das Triggersignal eine Abkopplung des Schattenregisters bewirkt.

Durch die eingebaute Logik kann die Abkopplung sehr schnell bei Auftreten vorbestimmter Ereignisse ausgelöst werden. Das Triggersignal kann dann die Abkopplung eines oder mehrerer Schattenregister sofort oder mit einer vorbestimmten Verzögerung auslösen. Eine solche Logik kann auf verschiedene Arten implementiert werden. Beispiele dazu finden sich in den Ausführungsbeispielen.

In einer bevorzugten Ausgestaltung werden vor dem Einfügen des Schattenregisters folgende Schritte durchgeführt werden:
- Ermitteln aller Konstanten im FPGA-Quellcode von denen der erste Signalwert abhängt,
- Ermitteln der minimal erforderlichen Bitbreiten für die gefundenen Werte der Konstanten
- Umkonfiguration der Konstanten auf die jeweils ermittelte minimal erforderliche Bitbreite oder nachträgliches Casting der Konstanten auf die jeweils ermittelte minimale erforderliche Bitbreite
- Durchpropagierung der Bitbreiten durch das gesamte FPGA Modell.

Konstantenblöcke in graphischen FPGA Modellen, bzw. VHDL Signale in VHDL Modellen werden häufig mit fester Bitbreite (z.B. 32 Bit) instanziiert. Bei der anschließenden Festlegung der Werte kommen jedoch meistens Werte zum Einsatz, die den Wertebereich der angegebenen Bitbreite nicht ausreizen. Der aus dem graphischen Modell generierte VHDL Code enthält ebenfalls die vollen Bitbreiten, unabhängig von den tatsächlich benötigten Bitbreiten. Bei der Handprogrammierung von VHDL Code geht man in der Regel ebenso vor.

Das ist normalerweise kein Problem, da die nicht benötigten Bits durch Synthese- und Implementierungswerkzeuge wegoptimiert werden, um Logik- und Routingressourcen einzusparen.

Die eingefügten Schattenregister, die zum Auslesen über eine externe Schnittstelle eingerichtet sind, werden jedoch von den Synthese- und Implementierungswerkzeugen nicht optimiert, da diese Werkzeuge externe Zugänge nicht optimieren. Um den Ressourcenverbrauch durch die eingefügten Schattenregister und die Ausleselogik gering zu halten, ist es daher vorteilhaft die minimalerforderliche Bitbreite der Konstanten und aller von den Konstanten abhängigen Signale zu ermitteln. Dann kann das Schattenregister in der minimal benötigten Bitbreite des zugeordneten Signals implementiert werden.

In einer weiteren Ausgestaltung wird das Schattenregister vor einer Wegoptimierung bei der Erstellung und/oder Weiterverarbeitung der Netzliste geschützt.

Register, die keine Ausgänge haben werden im Allgemeinen von den automatisierten Werkzeugen, die für die Erstellung und Weiterverarbeitung der Netzliste genutzt werden, wegoptimiert, d.h. gelöscht. Dies ist im Allgemeinen sinnvoll, da diese Register ansonsten Ressourcen im FPGA belegen ohne zu seiner Funktion beizutragen. Die im erfindungsgemäßen Verfahren eingefügten Schattenregister, die über eine Readbackschnittstelle ausgelesen werden sollen, haben keine Ausgänge und würden daher von den Werkzeugen gelöscht werden. Die Schattenregister werden allerdings benötigt, um die Signalwerte zur Laufzeit aus dem FPGA auslesen zu können. Daher ist es vorteilhaft die Schattenregister vor der Wegoptimierung zu schützen. Eine Möglichkeit dies zu erreichen ist es den Schattenregistern und den darin enthaltenen Signalen Attribute mitzugeben, wobei die Attribute von den Werkzeugen erkannt werden und die Werkzeuge dazu veranlasst keine Optimierungsmaßnahmen an den Registern vornehmen.

Eine Kombination der vor einer Wegoptimierung geschützten Schattenregister mit den oben genannten Schritten zur Ermittlung der minimal benötigten Bitbreite ist besonders vorteilhaft.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben auch keine ableitbare geometrische Relationen zueinander auf. Darin zeigt:
- Figur 1: eine schematische Ansicht einer ersten erfindungsgemäßen Ausführungsform,
- Figur 2: eine schematische Ansicht einer zweiten erfindungsgemäßen Ausführungsform,
- Figur 3: eine schematische Ansicht einer dritten erfindungsgemäßen Ausführungsform,
- Figur 4: eine schematische Ansicht einer vierten erfindungsgemäßen Ausführungsform
- Figur 5: eine schematische Darstellung des Verhaltens der ersten, zweiten und dritten Ausführungsform
- Figur 6: eine schematische Darstellung einer Netzliste, mit Vorbereitung für ein Auslesen der Register über eine Readbackschnittstelle
- Figur 7: eine schematische Abkopplungsschaltung mit Unterbrechung der Clock-Leitung
- Figur 8: eine schematische Abkopplungsschaltung mit Unterbrechung der enable-Leitung
- Figur 9: die Schritte eines erfindungsgemäßen Verfahrens

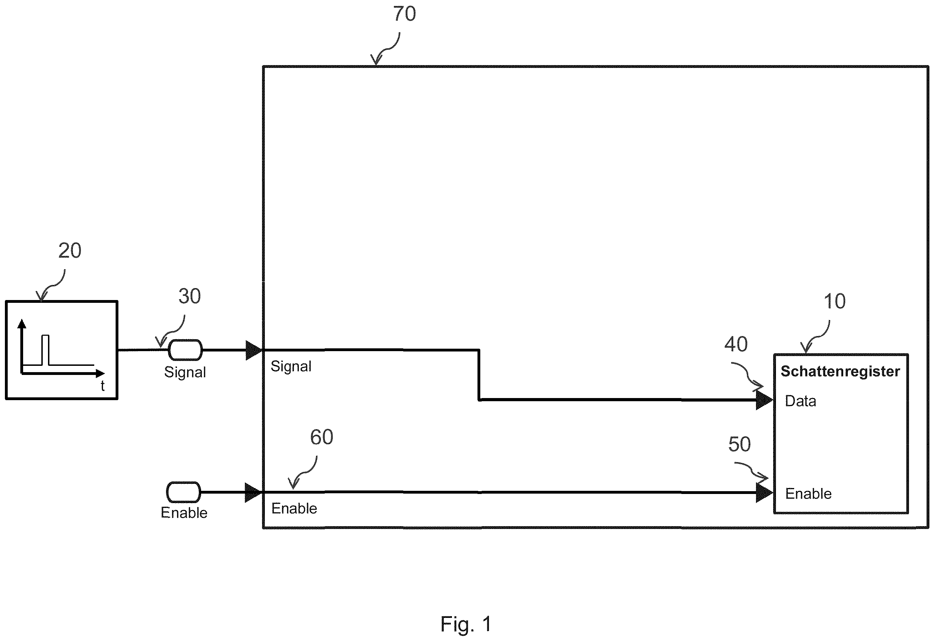

Das Verfahren wird in den Figuren 1 bis 4 anhand von schematisiertem grafischen FPGA-Quellcode erläutert. Es versteht sich, dass das Verfahren analog mit textuellem FPGA-Quellcode durchgeführt werden kann. Aus dem FPGA-Quellcode kann jeweils eine Netzliste erzeugt werden, die auf einen FPGA geladen werden kann, wodurch der FPGA die im FPGA-Quellcode definierte Funktion ausführen kann.

Die Abbildung der Figur 1 zeigt eine Ansicht einer ersten Ausführungsform, aufweisend ein Schattenregister 10 im Freilauf-Modus. In einem FPGA-Quellcode 20 ist eine Funktion mit einem Signal 30 definiert. Das Signal 30 wird dem Schattenregister 10 zugeordnet. Das Schattenregister 10 besitzt zwei Eingänge 40, 50. Einen ersten Eingang 40 für das Signal 30 und einen zweiten Eingang 50 für ein enable-Signal 60. Mit dem enable-Signal 60 kann das Schattenregister 10 aktiv geschaltet werden. Nur im aktiven Zustand nimmt das Schattenregister 10 den aktuellen Signalwert des zugeordneten Signals 30 an. Das enable-Signal 60 kann dauerhaft anliegen und nur zum gewünschten Zeitpunkt unterbrochen werden, um den aktuellen Wert dauerhaft im Schattenregister zu speichern. Alternativ kann das enable-Signal 60 nur kurzzeitig angelegt werden, um den zum Zeitpunkt des aktiven enable-Signals aktuellen Signalwert des Signals 30 dauerhaft im Schattenregister zu speichern. Der während des Verfahrens eingefügte Teil 70 umfasst in diesem Beispiel das Schattenregister 10 und die Leitungen für das Signal 30 und das enable-Signal 60. Das enable-Signal 60 wird bevorzugt von außen an den FPGA angelegt. Es ist aber auch möglich das enable-Signal 60 vom FPGA steuern zu lassen.

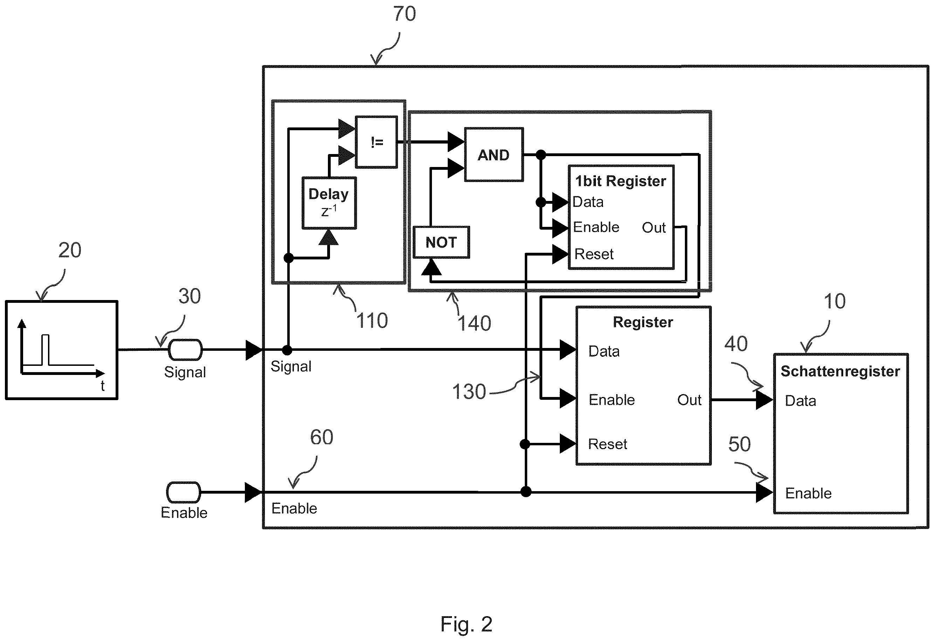

In der Abbildung der Figur 2 ist eine zweite Ausführungsform dargestellt. Im Folgenden werden nur die Unterschiede zu der Abbildung der Figur 1 erläutert. Ein Zwischenregister 100, das auch als zweites Schattenregister betrachtet werden kann, wird mit dem Signal 30 und dem Schattenregister 10 verbunden. In dem Zwischenregister 100 können aktuelle Signalwerte gespeichert werden, während das Schattenregister abgekoppelt ist. Eine zweiteilige Logikschaltung 110, 140 wird mit dem Signal 30 und dem Zwischenregister 100 verbunden. Der erste Teil der Logikschaltung 110 erkennt zur Laufzeit, dass eine Änderung des Signalwertes stattgefunden hat. Der zweite Teil der Logikschaltung 140 erzeugt bei einer durch den ersten Teil der Logikschaltung 110 erkannten Signalwertänderung ein Triggersignal 130, das als enable-Signal für das zweite Register dient. Die Logikschaltung 110, 140 ist so aufgebaut, dass das Triggersignal 130 bei einer Änderung des Signalwertes nur für einen Takt erzeugt wird. Dadurch wird nur der erste geänderte Signalwert im Zwischenregister 100 gespeichert. Das enable-signal 60 ermöglicht die Übernahme des im Zwischenregister 100 gespeicherten Signalwertes in das Schattenregister 10. Aus dem Schattenregister 100 kann der Wert dann ausgelesen werden, bspw. über eine Readbackschnittstelle. Das enable-Signal 60 dient auch als Reset-Signal für die Logikschaltung 110, 140 und das Zwischenregister 100. Die Logikschaltung 110 140 ist so ausgelegt, dass sie erst nach einem Empfang des Reset-Signals ein neues Triggersignal 130 erzeugt. Der Reset des Zwischenregisters 100 ermöglicht es in den ausgelesenen Daten klar zu unterscheiden ob ein aktueller Wert ausgelesen wurde oder nur der Inialisierungswert des Registers nach einem Reset.

Es versteht sich, dass das Triggersignal 130 auch an andere eingefügte Schaltungen weitergeleitet werden kann. So kann ein Triggersignal die Speicherung einer Vielzahl von Signalwerten auslösen. Dies ist vorteilhaft, wenn ein konsistenter Satz von Signalwerten, die gleichzeitig im FPGA vorliegen, erfasst werden soll.

Der während des Verfahrens eingefügte Teil 70 umfasst in diesem Beispiel das Schattenregister 10, das Zwischenregister 100 und die zweiteilige Logikschaltung 110, 140.

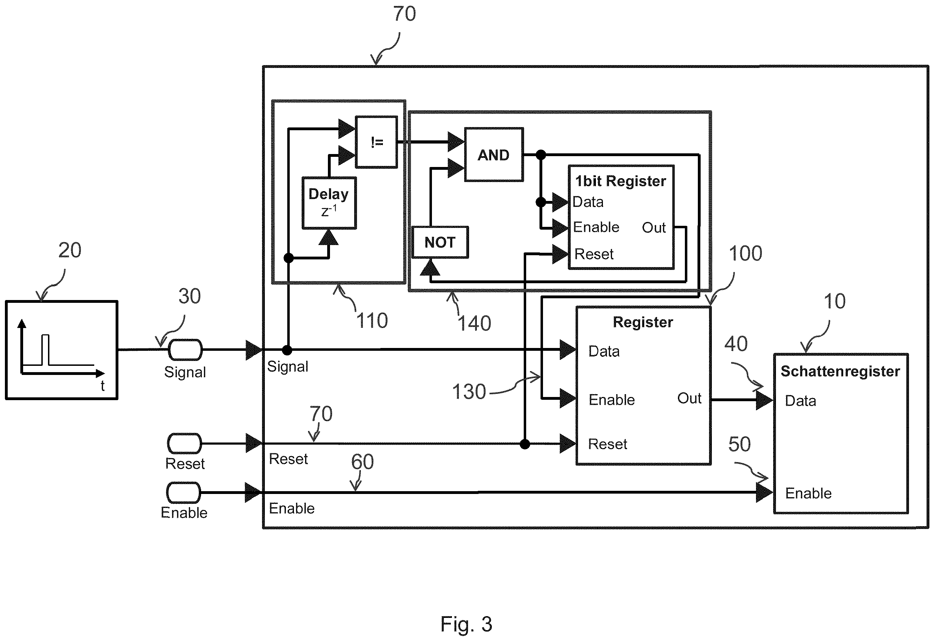

In der Abbildung der Figur 3 ist eine dritte Ausführungsform dargestellt. Im Folgenden werden nur die Unterschiede zu der Abbildung der Figur 2 erläutert. Das enablie-Signal 60 dient hier nicht als Reset-Signal für das zweite Register 100 und die zweiteilige Logik-Schaltung 110, 140. Das enable-Signal 60 dient nur der Übernahme des Signalwertes in das Schattenregister 10. Das Reset-Signal 70 für die Logikschaltung 110, 140 und das Zwischenregister 100 ist getrennt vom enable-Signal 60 und kann je nach Implementierung von außerhalb oder innerhalb des FPGAs angesteuert werden.

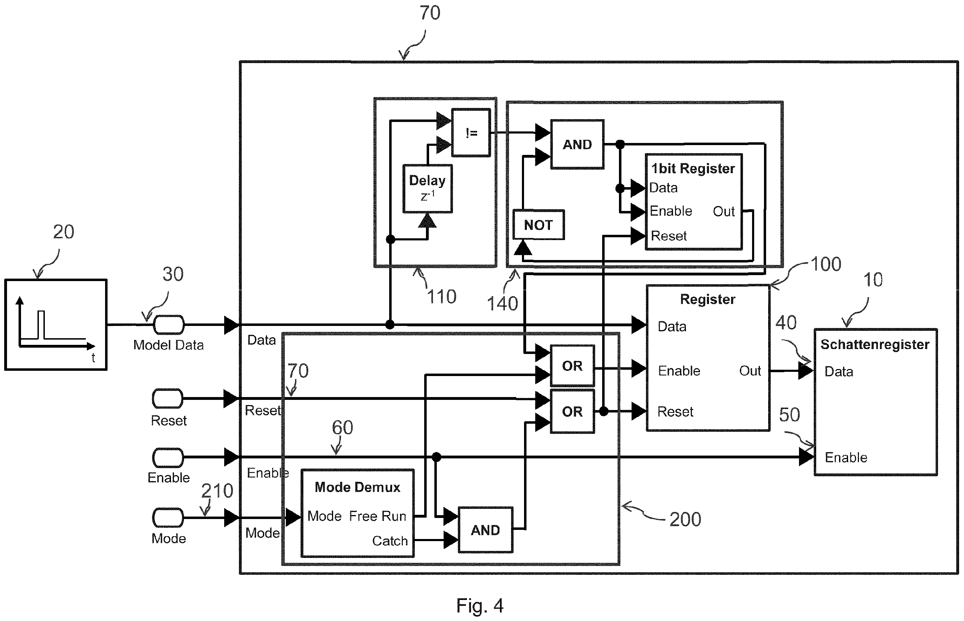

In der Abbildung der Figur 4 ist eine vierte Ausführungsform dargestellt. Im Folgenden werden nur die Unterschiede zu der Abbildung der Figur 3 erläutert. Es wird eine Modusumschaltungslogik 200 eingefügt. Die Modusumschaltungslogik 200 erhält das Reset-Signal 70, das enable-Signal 60 eine ein Modus-Signal 210 als Eingaben. Abhängig vom Wert des Modus-Signal 210 kann die zweiteilige Logikschaltung 110, 140 übersteuert werden, sodass sich die Schaltung der vierten Ausführungsform wie die Schaltung der ersten Ausführungsform aus Figur 1 verhält. Zusätzlich wird in Abhängigkeit vom Modus-Signal 210 das enable-Signal 60 als Reset-Signal für das Zwischenregister 100 und die zweiteilige Logikschaltung 110, 140 verwendet, sodass sich die Schaltung wie die Schaltung der zweiten Ausführungsform aus Figur 2 verhält. Liegt kein Modus-Signal 210 an, so verhält sich die Schaltung wie die Schaltung der dritten Ausführungsform aus Figur 3. Die vierte Ausführungsform stellt also eine Kombination der ersten drei Ausführungsformen dar, der Verhalten durch das Modus-Signal 210 zur Laufzeit gewählt werden kann. Dies ist vorteilhaft, wenn bei der Erstellung der Netzliste noch nicht feststeht welches Verhalten erwünscht ist.

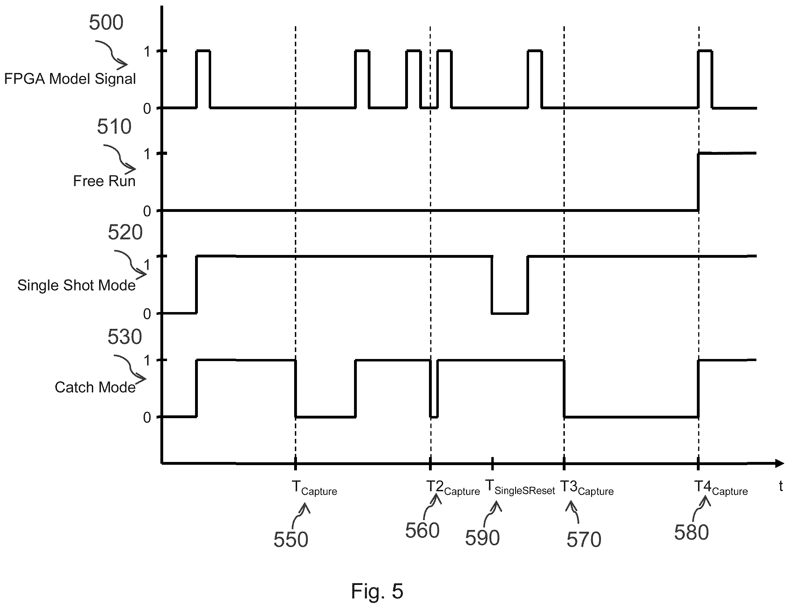

Die Abbildung in Figur 5 zeigt eine schematische Darstellung des Verhaltens der ersten, zweiten und dritten Ausführungsform.

Die oberste Zeile 500 zeigt einen beispielhaften Signalverlauf des Signal 30. Über die Zeit wechselt der Signalwert mehrfach zwischen 0 und 1.

Die zweite Zeile 510 zeigt den Wert des Schattenregisters 10 am Beispiel des ersten Ausführungsbeispiels aus Figur 1. Das enable-Signal 60 wird zu vier unterschiedlichen Zeiten 550, 560, 570, 580 jeweils kurz aktiviert. Da der Wert des Schattenregisters nur bei aktivem enable-Signal 60 aktualisiert wird, bleibt der Wert des Schattenregisters 10 solange 0 bis der Signalwert 30 1 ist und gleichzeitig das enable-Signal aktiv ist. Aus dem Schattenregister kann der Wert dann ausgelesen werden.

Die dritte Zeile 520 zeigt den Wert des Zwischenregisters 100 am Beispiel des dritten Ausführungsbeispiels aus Figur 3. Bei der ersten Änderung des Signalwertes des Signals 30 löst die zweiteilige Logikschaltung 110, 140 das Triggersignal 130 aus und der aktuelle Wert wird in das Zwischenregister 100 übernommen. Das Reset-Signal 70 wird zu einem fünften Zeitpunkt 590 aktiv. Das Reset-Signal 70 setzt den Wert des Zwischenregisters 100 auf 0 und setzt die zweiteilige Logikschaltung 110, 140 zurück, sodass bei der nächsten Änderung des Signalwertes des Signals 30 wieder ein Triggersignal 130 erzeugt wird. Jedes Mal wenn das enable-Signal 60 zu einem der vier angezeigten Zeitpunkte 550, 560, 570, 580 aktiv ist, wird der zu diesen Zeiten aktuelle Wert des Zwischenregisters 100 in das Schattenregister 10 übernommen und kann von dort ausgelesen werden.

Die vierte Zeile 530 zeigt den Wert des Zwischenregisters 100 am Beispiel des zweiten Ausführungsbeispiels aus Figur 2. Bei der ersten Änderung des Signalwertes des Signals 30 löst die zweiteilige Logikschaltung 110, 140 das Triggersignal 130 aus und der aktuelle Wert wird in das Zwischenregister 100 übernommen. Jedes Mal wenn das enable-Signal 60 zu einem der vier angezeigten Zeitpunkte 550, 560, 570, 580 aktiv ist, wird der zu diesen Zeiten aktuelle Wert des Zwischenregisters 100 in das Schattenregister 10 übernommen und kann von dort ausgelesen werden.

Zugleich setzt das enable-Signal 60 den Wert des Zwischenregisters 100 auf 0 und setzt die zweiteilige Logikschaltung 110, 140 zurück, sodass bei der nächsten Änderung des Signalwertes des Signals 30 wieder ein Triggersignal 130 erzeugt wird.

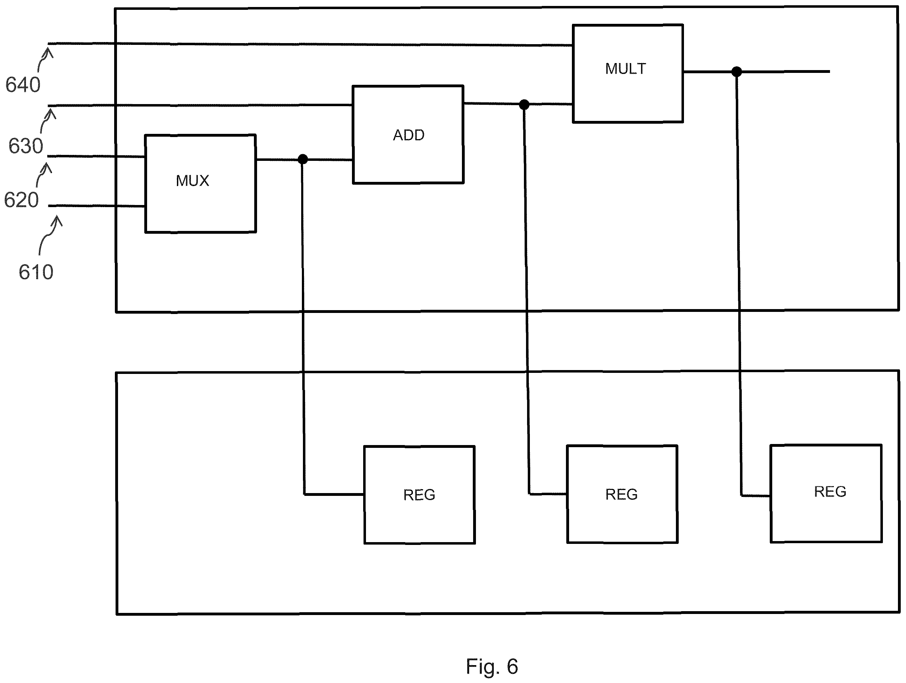

Figur 6 zeigt eine schematische Darstellung einer Netzliste, mit Vorbereitung für ein Auslesen der Register über eine Readbackschnittstelle. Die Netzliste besteht aus drei Logikblöcken MUX, ADD, MULT und mehreren Leitungen. Zwei Eingängen 610, 620 der Netzliste werden in zwei Eingänge des ersten Logikblocks MUX geführt. Der Ausgang des ersten Logikblocks MUX wird mit einem ersten Eingang des zweiten Logikblocks ADD verbunden. Ein dritter Eingang 630 der Netzliste wird mit einem zweiten Eingang des zweiten Logikblocks ADD verbunden. Der Ausgang des zweiten Logikblocks ADD wird mit einem ersten Eingang des dritten Logikblocks MULT verbunden. Ein vierter Eingang 640 der Netzliste wird mit einem zweiten Eingang des dritten Logikblocks MULT verbunden. Der Ausgang des dritten Logikblocks bildet den Ausgang der Netzliste. In diese Netzliste werden drei Schattenregister REG eingefügt. Jedes Schattenregister REG wird jeweils einem Ausgangssignal eines Logikblocks zugeordnet. Die Schattenregister REG sind zum Auslesen über eine Readbackschnittstelle vorgesehen und eingerichtet, daher wird keine Ausleselogik in die Netzliste eingefügt. Die Schattenregister lassen sich über eine Abkopplungsschaltung im gleichen Taktschritt von den Logikblöcken funktional trennen. Dadurch kann in den Schattenregistern ein konsistenter Datensatz festgehalten werden.

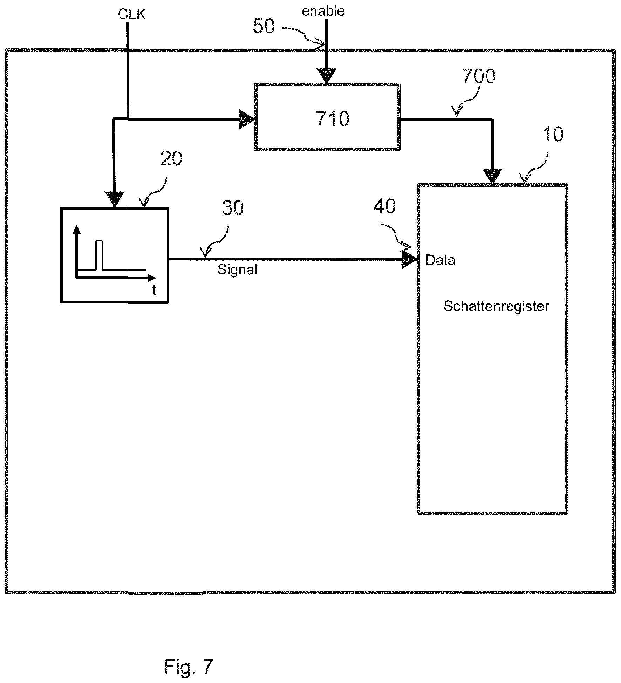

Figur 7 zeigt eine schematische Abkopplungsschaltung mit Unterbrechung des Taktsignals. Das Taktsignal 700 der Schattenregister wird über einen eingefügten Abkopplungsmechanismus 710 mit dem Taktnetz CLK des dem Schattenregister zugeordneten Signals verbunden. Der Abkopplungsmechanismus kann von innerhalb und/oder außerhalb des FPGAs zur Laufzeit angesprochen werden und das Taktsignal unterbrechen. Das dem Schattenregister 10 zugeordnete Signal 30 aus dem FPGA-Quellcode 20 wird fest mit dem Signaleingang 40 des Schattenregisters 10 verbunden. Das Schattenregister 10 nimmt nur dann einen aktuellen Signalwert an, wenn der Abkopplungsmechanismus 700 das Taktsignal des Schattenregisters 10 mit dem Taktnetz CLK verbindet.

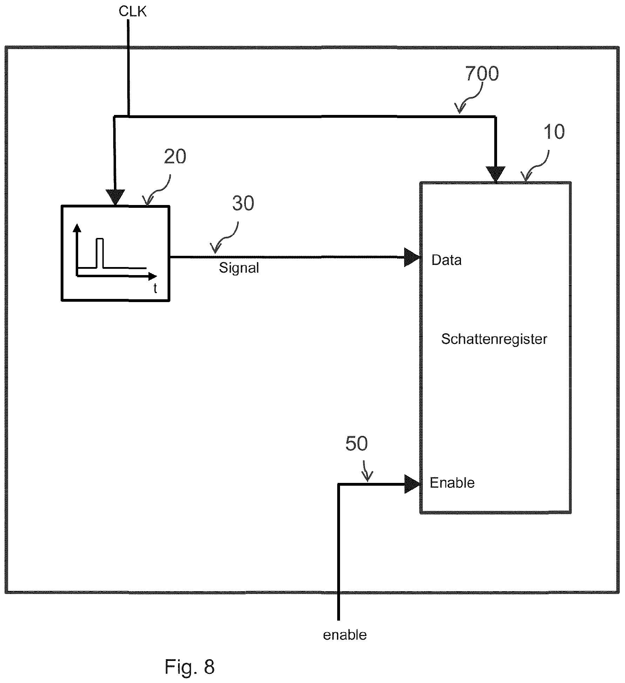

Figur 8 zeigt eine schematische Abkopplungsschaltung mit Unterbrechung des enable-Signals. Das Taktsignal 700 des Schattenregisters 10 wird in dieser Ausführungsform direkt mit dem Taktnetz CLK verbunden. Zum Abkoppeln des Schattenregisters 10 wird ein Abkopplungsmechanismus eingefügt und mit dem enable-Eingang 50 des Schattenregisters 10 verbunden. Der Abkopplungsmechanismus kann von innerhalb und/oder außerhalb des FPGAs zur Laufzeit angesprochen werden und das enable-Signal unterbrechen.

Auch FPGA-Programme mit mehreren Taktdomänen können auf die oben beschriebenen Arten sicher, d.h. ohne metastabile Zustände, betrieben werden. Dazu wird bei der Abkopplung mit Unterbrechung des Taktsignals das Schattenregister an das Taktnetz angeschlossen mit dem auch das zugeordnete Signal betrieben wird. Bei einer Vielzahl von Schattenregistern, die unterschiedlichen Signalen zugeordnet sind, werden die Taktleitungen der Schattenregister an das jeweilige Taktnetz der zugeordneten Signale angeschlossen. Bei der Abkopplung mit Unterbrechung der enable-Leitung wird für jede Taktdomäne in der FPGA-Netzliste ein eigenes Enable Signal mit korrektem Taktdomänenübergang eingefügt und an die Enable Ports der Schattenregister der jeweiligen Taktdomänen angeschlossen. Ein Taktdomänenübergang kann z.B. durch doppelte Register korrekt überschritten werden.

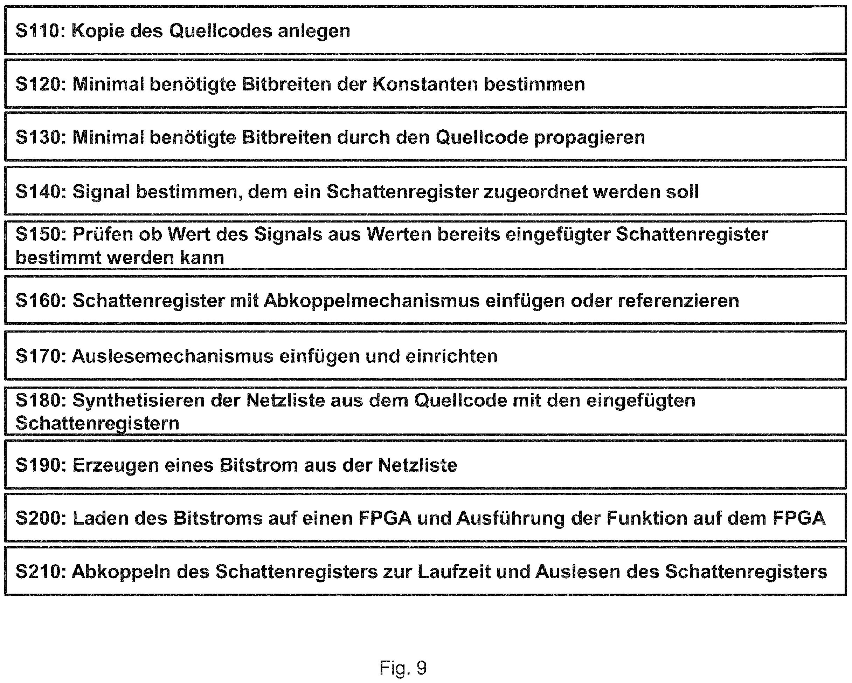

Figur 9 zeigt die Schritte eines erfindungsmäßen Verfahrens. Einige Schritte sind dabei obligatorisch, andere Schritte sind optional. In einem ersten optionalen Schritt S110 wird eine Kopie des Quellcodes angelegt. In einem zweiten optionalen Schritt 120 werden die minimal benötigten Bitbreiten der Konstanten in dem Quellcode bzw. der Kopie des Quellcodes bestimmt. In einem dritten optionalen Schritt S130 werden die im zweiten Schritt S120 bestimmten minimal benötigten Bitbreiten durch den Quellcode propagiert. In einem vierten obligatorischen Schritt S140 wird ein Signal 30 bestimmt, dem ein Schattenregister 10 zugeordnet werden soll. Dieser Schritt kann automatisiert durch einen Algorithmus oder durch Nutzereingabe geschehen. In einem fünften optionalen Schritt S150 wird geprüft ob der Wert des im vierten Schritt S140 bestimmten Signals aus Werten bereits eingefügter Schattenregister bestimmt werden kann. In einem sechsten obligatorischen Schritt S160 wird für das im vierten Schritt S140 bestimmte Signal 30 ein Schattenregister 10 eingefügt. Zusätzlich wird für das Schattenregister 10 ein Abkoppelmechanismus eingefügt und eingerichtet oder das Schattenregister 10 mit einem bereits eingefügten Abkoppelmechanismus verbunden. Falls im fünften Schritt S150 festgestellt wurde, dass der Werts des im vierten Schritt S140 bestimmten Signal 30 aus bereits eingefügten Schattenregistern bestimmt werden kann, so wird im sechsten Schritt S160 kein Schattenregister einfügt, sondern auf die bereits eingefügten Schattenregister referenziert, aus denen sich der Wert des Signals bestimmen lässt. In einem siebten obligatorischen Schritt S170 wird für das im sechsten Schritt S160 eingefügte Schattenregister 10 ein Auslesemechanismus eingefügt und eingerichtet. Das Einfügen und Einrichten des Auslesemechanismus kann z.B. darin bestehen, dass in den Quellcode eine Anweisung an die Implementierungswerkzeuge eingefügt wird, dass auf dem FPGA, auf den die Netzliste geladen werden soll, das Auslesen über eine Readbackschnittstelle ermöglicht werden soll. Der vierte bis siebte Schritt können mehrfach wiederholt werden, um einer Vielzahl von Signalen Schattenregister zuzuordnen. Bevorzugt werden der vierte bis siebte Schritt automatisiert durch einen Algorithmus wiederholt abgearbeitet, wobei der Algorithmus systematisch alle im Quellcode definierten Signale abarbeitet.

In einem obligatorischen achten Schritt S180 wird aus dem Quellcode eine Netzliste synthetisiert. Es sei angemerkt, dass der achte Schritt S180 auch vor dem vierten Schritt S140 durchgeführt werden kann. In jedem Fall enthält die Netzliste sowohl die Information des ursprünglichen Quellcodes als auch die eingefügten Schattenregister mit dem eingerichteten Abkopplungsmechanismus und den eingerichteten Auslesemechanismus. In einem optionalen neunten Schritt S190 wird die im achten Schritt S180 erzeugte Netzliste in einen Bitstrom umgewandelt, der dann in einem optionalen zehnten Schritt S200 auf einen FPGA geladen und dort zur Ausführung gebracht werden kann. Zur Laufzeit des FPGA kann dann in einem optionalen elften Schritt S210 das im sechsten Schritt S160 eingefügte Schattenregister 10 über den Abkoppelmechanismus von der Funktion des ursprünglichen Quellcodes abgekoppelt und über den im siebten Schritt S170 eingerichteten Auslesemechanismus ausgelesen werden. Die oligatorischen Schritte des Verfahrens ermöglichen das sichere Auslesen des Wertes des im vierten Schritt S140 bestimmten Signals 30 zur Laufzeit des FPGA.

## Patentansprüche

1. Verfahren zum Erstellen einer FPGA-Netzliste,
wobei das Verfahren durch eine Datenverarbeitungseinrichtung mit einer Prozessoreinheit durchgeführt wird,
wobei die Netzliste aus einem FPGA-Quellcode (20) und zumindest einem Schattenregister (10) erzeugt wird,
wobei der FPGA-Quellcode (20) zumindest eine Funktion und zumindest ein Signal (30) definiert,
wobei das Schattenregister (10) dem zumindest einen Signal (30) zugeordnet wird und dazu eingerichtet und vorgesehen wird den Wert des zugeordneten Signals (30) zur Laufzeit zu speichern,
wobei eine Möglichkeit zum Auslesen des gespeicherten Signalwertes zur Laufzeit vorgesehen und eingerichtet wird,
wobei die im FPGA-Quellcode (20) definierte Funktion durch das Schattenregister (10) nicht verändert wird,
wobei die Netzliste in einen Bitstrom umgewandelt und auf einen FPGA geladen und von dem FPGA zur Ausführung gebracht wird, wobei die vom FPGA-Quellcode (20) beschriebene Funktion vom FPGA ausgeführt wird,
wobei das Schattenregister (10) automatisiert eingefügt und dem Signal (30) zugeordnet wird,
wobei eine funktionale Abkopplung des Schattenregisters (10) von der im FPGA-Quellcode (20) beschriebenen Funktion vorgesehen und eingerichtet wird,
wobei das Schattenregister (10) durch die Abkopplung den zum Zeitpunkt der Abkopplung gespeicherten Signalwert beibehält, während die im FPGA-Quellcode (20) beschriebene Funktion ausgeführt wird.

2. Verfahren nach einem der vorhergehenden Ansprüche **dadurch gekennzeichnet, dass**
der FPGA-Quellcode (20) ein Vielzahl von Signalen (30) definiert,
wobei eine Vielzahl von Schattenregistern (10) jeweils einem Signal (30) zugeordnet wird,
wobei die funktionale Abkopplung dazu vorgesehen ist die Vielzahl an Schattenregistern (10) synchron abzukoppeln.

3. Verfahren nach einem der vorhergehenden Ansprüche **dadurch gekennzeichnet, dass**
zur Abkopplung das enable-Signal (60) des Schattenregisters (10) oder das Taktsignal (700) des Schattenregisters (10) unterbrochen wird.

4. Verfahren nach einem der vorhergehenden Ansprüche, **dadurch gekennzeichnet, dass**
der FPGA-Quellcode (20) als grafisches Modell oder als textueller Code vorliegt.

5. Verfahren nach einem der vorhergehenden Ansprüche, **dadurch gekennzeichnet, dass**
das Schattenregister (10) in den FPGA-Quellcode (20) oder eine Kopie des FPGA-Quellcodes (20) eingefügt wird.

6. Verfahren nach einem der vorhergehenden Ansprüche, **dadurch gekennzeichnet, dass**
aus dem Quellcode (20) eine Netzliste generiert wird und das Schattenregister (10) in die Netzliste eingefügt wird.

7. Verfahren nach Anspruch, **dadurch gekennzeichnet, dass** automatisiert geprüft wird, ob das Signal (30) bereits an anderer Stelle des Quellcodes (20) einem Schattenregister (10) zugeordnet ist und dann dem Signal (30) kein weiteres Schattenregister (10) zugeordnet wird.

8. Verfahren nach einem der Ansprüche, **dadurch gekennzeichnet, dass** mindestens zwei Schattenregister (10, 100) eingefügt und dem Signal (30) zugeordnet werden, wobei das erste Schattenregister (100) dazu vorgesehen und eingerichtet wird zur Laufzeit einen aktuellen Signalwert zu speichern, während das zweite Schattenregister (10) abgekoppelt ist.

9. Verfahren nach einem der vorhergehenden Ansprüche, **dadurch gekennzeichnet, dass**
beim Erstellen der Netzliste ein Auslesen des Schattenregisters (10) über eine externe und/oder interne Readbackschnittstelle des FPGAs vorgesehen und eingerichtet wird.

10. Verfahren nach einem der Ansprüche, **dadurch gekennzeichnet, dass** eine Vielzahl von Schattenregistern (10) eingefügt wird,
wobei die Vielzahl von Schattenregistern (10) zu einer Schieberegisterkette verbunden werden und dazu vorgesehen und eingerichtet werden über eine externe Schnittstelle des FPGAs ausgelesen zu werden.

11. Verfahren nach einem der Ansprüche, **dadurch gekennzeichnet, dass** eine Vielzahl von Schattenregistern (10) eingefügt werden,
wobei ein Adressdecoder zum Auslesen der Vielzahl von Schattenregistern (10) über eine externe Schnittstelle des FPGA vorgesehen und eingerichtet wird.

12. Verfahren nach einem der vorhergehenden Ansprüche, **dadurch gekennzeichnet, dass**
zusätzlichem zum Schattenregister eine Logik (110, 140) eingefügt wird,
wobei die Logik (110, 140) dazu vorgesehen und eingerichtet wird zur Laufzeit bei einer Änderung des Signalwertes ein Triggersignal (130) auszugeben, wobei das Triggersignal (130) eine Abkopplung des Schattenregisters bewirkt.

13. Verfahren nach einem der vorhergehenden Ansprüche, **dadurch gekennzeichnet, dass**
vor dem Einfügen des Schattenregisters (10) folgende Schritte durchgeführt werden:
- Ermitteln aller Konstanten im FPGA-Quellcode (20) von denen der erste Signalwert (30) abhängt,
- Ermitteln der minimal erforderlichen Bitbreiten für die gefundenen Werte der Konstanten
- Umkonfiguration der Konstanten auf die jeweils ermittelte minimal erforderliche Bitbreite oder nachträgliches Casting der Konstanten auf die jeweils ermittelte minimale erforderliche Bitbreite
- Durchpropagierung der Bitbreiten durch den FPGA Quellcode.

14. Verfahren nach einem der vorhergehenden Ansprüche, **dadurch gekennzeichnet, dass**
das Schattenregister (10) vor einer Wegoptimierung bei der Erstellung und/oder Weiterverarbeitung der Netzliste geschützt wird.

## Claims

1. A method for creating an FPGA network list,
the method being performed by a data processing device having a processor unit,
the network list generated from an FPGA source code (20) and at least one shadow register (10),
the FPGA source code (20) defining at least one function and at least one signal (30),
the shadow register (10) being associated with the at least one signal (30) and set up and provided for storing the value of the associated signal (30) during runtime, an option of reading out the stored signal value during runtime being provided and set up,
the function defined in the FPGA source code (20) not being modified by the shadow register (10),
the network list being converted into a bit stream and loaded onto an FPGA and implemented by the FPGA,
the function described by the FPGA source code (20) being implemented by the FPGA,
the shadow register (10) being automatically inserted and associated with the signal (30),
a functional decoupling of the shadow register (10) from the function described in the FPGA source code (20) being provided and set up,
the shadow register (10) retaining the signal value stored at the point in time of the decoupling due to the decoupling, while the function described in the FPGA source code (20) is implemented.

2. The method according to any one of the preceding claims, **characterized in that**
the FPGA source code (20) defines a plurality of signals (30),
wherein a plurality of shadow registers (10) is each associated with a signal (30),
wherein the functional decoupling is provided to decouple the plurality of shadow registers (10) synchronously.

3. The method according to any one of the preceding claims, **characterized in that**
the decoupling the enable signal (60) of the shadow register (10) or the clock signal (700) of the shadow register (10) is interrupted.

4. The method according to any one of the preceding claims, **characterized in that**
the FPGA source code (20) exists as a graphic model or as textual code.

5. The method according to any one of the preceding claims, **characterized in that**
the shadow register (10) is inserted into the FPGA source code (20) or a copy of the FPGA source code (20) .

6. The method according to any one of the preceding claims, **characterized in that**
a network list is generated from the source code (20) and the shadow register (10) is inserted into the network list.

7. The method according to claim, **characterized in that** it is automatically checked whether the signal (30) is already associated with a shadow register (10) elsewhere in the source code (20) and then no further shadow register (10) is associated with the signal (30).

8. The method according to any one of the claims, **characterized in that** at least two shadow registers (10, 100) are inserted and associated with the signal (30), wherein the first shadow register (100) is provided and set up to store a current signal value during runtime, while the second shadow register (10) is decoupled.

9. The method according to any one of the preceding claims, **characterized in that**
when creating the network list, a reading out of the shadow register (10) by means of an external and/or internal readback interface of the FPGA is provided and set up.

10. The method according to any one of the claims, **characterized in that** a plurality of shadow registers (10) is inserted,
wherein the plurality of shadow registers (10) are connected to form a shift register chain and are provided and set up to be read out by means of an external interface of the FPGA.

11. The method according to any one of the claims, **characterized in that** a plurality of shadow registers (10) is inserted,
wherein an address decoder is provided and set up for reading out the plurality of shadow registers (10) by means of an external interface of the FPGA.

12. The method according to any one of the preceding claims, **characterized in that**
a logic (110, 140) is additionally inserted into the shadow register,
wherein the logic (110, 140) is provided and set up to output a trigger signal (130) during runtime when the signal value changes, wherein the trigger signal (130) causes the shadow register to be decoupled.

13. The method according to any one of the preceding claims, **characterized in that**
before inserting the shadow register (10), the following steps must be performed:
- determining all constants in the FPGA source code (20) on which the first signal value (30) depends,
- determining the minimum required bit widths for the found values of the constants
- reconfiguring the constants to the respectively determined minimum required bit width or subsequent casting of the constants to the respectively determined minimum required bit width
- propagating the bit widths through the FPGA source code.

14. The method according to any one of the preceding claims, **characterized in that**
the shadow register (10) is protected from route optimization during the creation and/or further processing of the network list.

## Revendications

1. Procédé pour créer une liste d'interconnexions d'un FPGA,
dans lequel le procédé est exécuté par un dispositif de traitement de données comprenant une unité de processeur, dans lequel la liste d'interconnexion est générée à partir d'un code source FPGA (20) et d'au moins un registre fantôme (10), le code source FPGA (20) définissant au moins une fonction et au moins un signal (30),
dans lequel le registre fantôme (10) est attribué à l'au moins un signal (30) et est configuré et prévu pour mémoriser la valeur du signal associé (30) pendant la durée d'exécution,
dans lequel une possibilité pour la lecture de la valeur de signal mémorisée sur la durée d'exécution est prévue et configurée,
dans lequel la fonction définie dans le code source FPGA (20) n'est pas modifiée par le registre fantôme (10),
dans lequel la liste d'interconnexions est convertie en un train de bits et chargée sur un FPGA, puis mise en exécution par le FPGA,
dans lequel la fonction décrite par le code source FPGA (20) est exécutée par le FPGA,
dans lequel le registre fantôme (10) est automatiquement inséré et attribué au signal (30),
dans lequel un découplage fonctionnel du registre fantôme (10) de la fonction décrite dans le code source FPGA (20) est prévu et configuré,
dans lequel le registre fantôme (10), du fait du découplage, maintient la valeur de signal mémorisée au moment du découplage tandis qu'est exécutée la fonction décrite dans le code source FPGA (20).

2. Procédé selon l'une quelconque des revendications précédentes, **caractérisé en ce que**
le code source FPGA (20) définit une pluralité de signaux (30),
dans lequel une pluralité de registres fantômes (10) sont chacun attribués à un signal (30),
dans lequel le découplage fonctionnel est prévu pour découpler de manière synchrone la pluralité de registres fantômes (10).

3. Procédé selon l'une quelconque des revendications précédentes, **caractérisé en ce que**
pour le découplage, le signal de validation (60) du registre fantôme (10) ou le signal d'horloge (700) du registre fantôme (10) est interrompu.

4. Procédé selon l'une quelconque des revendications précédentes, **caractérisé en ce que**
le code source FPGA (20) est disponible sous forme de modèle graphique ou de code textuel.

5. Procédé selon l'une quelconque des revendications précédentes, **caractérisé en ce que**
le registre fantôme (10) est inséré dans le code source FPGA (20) ou une copie du code source FPGA (20).

6. Procédé selon l'une quelconque des revendications précédentes, **caractérisé en ce que**
une liste d'interconnexions est générée à partir du code source (20) et le registre fantôme (10) est inséré dans la liste d'interconnexions.

7. Procédé selon la revendication, **caractérisé en ce qu'**il est vérifié automatiquement si le signal (30) est déjà attribué à un registre fantôme (10) ailleurs dans le code source (20) et alors aucun autre registre fantôme (10) n'est attribué au signal (30).

8. Procédé selon l'une quelconque des revendications, **caractérisé en ce qu'**au moins deux registres fantômes (10, 100) sont insérés et attribués au signal (30), le premier registre fantôme (100) étant prévu et configuré pour mémoriser une valeur de signal actuelle pendant la durée d'exécution tandis que le deuxième registre fantôme (10) est découplé.

9. Procédé selon l'une quelconque des revendications précédentes, **caractérisé en ce que**
lors de la création de la liste d'interconnexions, une lecture du registre fantôme (10) via une interface de relecture externe et/ou interne du FPGA est prévue et configurée.

10. Procédé selon l'une quelconque des revendications, **caractérisé en ce qu'**une pluralité de registres fantômes (10) sont insérés,
dans lequel la pluralité de registres fantômes (10) sont connectés en une chaîne de registres à décalage et sont prévus et configurés pour être lus via une interface externe du FPGA.

11. Procédé selon l'une quelconque des revendications, **caractérisé en ce qu'**une pluralité de registres fantômes (10) sont insérés,
dans lequel un décodeur d'adresse pour lire la pluralité de registres fantômes (10) via une interface externe du FPGA est prévu et configuré.

12. Procédé selon l'une quelconque des revendications précédentes, **caractérisé en ce que**
une logique (110, 140) est insérée en plus du registre fantôme,
dans lequel la logique (110, 140) est prévue et configurée pour sortir un signal de déclenchement (130) pendant la durée d'exécution en cas de changement de la valeur du signal, le signal de déclenchement (130) provoquant le découplage du registre fantôme.

13. Procédé selon l'une quelconque des revendications précédentes, **caractérisé en ce que**
les étapes suivantes sont effectuées avant l'insertion du registre fantôme (10) :
- déterminer toutes les constantes dans le code source FPGA (20) dont dépend la première valeur de signal (30),
- déterminer les largeurs de bits minimales requises pour les valeurs trouvées des constantes
- reconfigurer les constantes à la largeur de bit minimale requise déterminée dans chaque cas ou conversion ultérieure des constantes à la largeur de bit minimale requise déterminée dans chaque cas
- propagation de bout en bout des largeurs de bits à travers le code source du FPGA.

14. Procédé selon l'une quelconque des revendications précédentes, **caractérisé en ce que**
le registre fantôme (10) est protégé contre une optimisation des itinéraires lors de la création et/ou le traitement ultérieur de la liste d'interconnexions.
